# EUROPÄISCHE PATENTSCHRIFT

(11) **EP 0 520 331 B1**
(45) Veröffentlichungstag und Bekanntmachung des Hinweises auf die Patenterteilung: **29.10.1997**
(21) Anmeldenummer: 92110377.6
(22) Anmeldetag: 19.06.1992
(51) Int. Cl.: H03K 4/62, H03K 17/61, H03K 17/0412

(54) **Horizontalablenkschaltung mit einem Treibertransformator**
Horizontal deflection circuit with a driving transformer
Circuit de déviation horizontale avec un transformateur de commande

(30) Priorität: 24.06.1991 DE 4120778
(43) Veröffentlichungstag der Anmeldung: 30.12.1992
(73) Patentinhaber: Nokia (Deutschland) GmbH, 75175 Pforzheim (DE)
(72) Erfinder: Erbach, Gerd, Dipl.-Ing., W-7530 Pforzheim (DE)

(56) Entgegenhaltungen:
- EP-A- 0 403 972
- GB-A- 2 177 564
- US-A- 4 864 247
- INTERNATIONAL JOURNAL OF ELECTRONICS Bd. 33, Nr. 3, September 1972, LONDON GB Seiten 281 - 288 S. K. SHARMA ET AL. 'Analysis of the line driver stage for transistorized T.V. receiver'
- PATENT ABSTRACTS OF JAPAN vol. 9, no. 56 (E-302)(1779) 12. März 1985 & JP-A-59 194 533 ( FUJI DENKI SEIZO K.K. ) 5. November 1984

## Beschreibung

Die Erfindung betrifft eine Horizontalablenkschaltung der im Oberbegriff des Anspruches 1 angegebenen Gattung.

Der Zeilenendstufentransistor einer derartigen Horizontalablenkschaltung ist dazu vorgesehen, die Ablenkspulen für die horizontale Strahlablenkung einer Fernsehröhre mit den erforderlichen Ablenkströmen zu versorgen.

Eine Horizontalablenkschaltung entsprechend der Gattung des Oberbegriffes des Anspruches 1 ist aus EP-A-0 403 972 bekannt. Die bekannte Horizontalablenkschaltung enthält einen von einem Zeilenfrequenzoszillator gesteuerten Treibertransistor, in dessen Kollektorkreis die Primärwicklung eines Treibertransformators angeordnet ist. Die Sekundärwicklung dieses Treibertransformators bildet mit dem Basiskreis eines Zeilenendstufentransistors dieser Horizontalablenkschaltung und einer Strombegrenzungsinduktivität einen Steuerkreis für den Zeilenendstufentransistor, in dem jeweils in der Stromflußphase des Treibertransistors einer jeden Schwingungsperiode der Zeilenablenkschwingung ein Steuerstrom fließt.

Der Erfindung liegt die Aufgabe zugrunde, eine Zeilenablenkschaltung mit einem Treibertransformator derart auszubilden, daß die Ein- und Ausschwingzeiten der Treiberstufe kleiner als die Periodendauer der Zeilenablenkschwingung ist, ohne daß dadurch der hohe Wirkungsgrad der Treiberstufe und der geringe Schaltungsaufwand nachteilig beeinflußt werden.

Diese Aufgabe wird nach der Erfindung durch die im kennzeichnenden Teil des Anspruches 1 angegebenen Merkmale gelöst.

Durch die Ausbildung der Treiberstufe als Durchflußwandler muß die Treiberstufe nur noch für die Deckung der Verlustenergien der Strömungsverluste des Treiberstromes im Steuerkreis des Zeilenendstufentransistors und für die Deckung der Ausräumung der elektrischen Basisladung des Zeilenendstufentransistors bemessen werden. Das erfordert für den Treibertransformator eine Energieübertragung von einer wesentlich geringeren magnetischen Energie als bei einem Sperrwandler. Diese wesentlich geringere magnetische Energiemenge pro Schwingungsperiode bedingt neben einer wesentlich geringeren Baugröße des Transformators eine leichtere Handhabung dieser Energie und zeitlich besser definierte Übertragungszeiten dieser Energie.

Der Unteranspruch kennzeichnet eine vorteilhafte Ausgestaltung der Erfindung. Vielfach enthält der Arbeitskreis des Treibertransistors ein sogenanntes Entlastungsnetzwerk, das den Treibertransistor vor unzulässig hohen Stromstößen oder Spannungsspitzen schützt. Dieses Entlastungsnetzwerk kann in einer vorteilhaften Ausbildung der Erfindung so ausgestaltet sein, daß es beim Abbruch des Ausräumstromes den vom Treibertransformator im Sperrzustand des Treibertransistors erzeugten Strom übernimmt. Besonders vorteilhaft ist es, die Treiberstufe so zu bemessen, daß die während einer Leitphase des Treibertransistors die in den Treibertransformator eingespeicherte magnetische Energie vollständig innerhalb der an die Leitphase anschließenden Sperrphase des Treibertransistors wieder abgebaut wird.

Die Erfindung wird im folgenden anhand eines vorteilhaften Ausführungsbeispieles näher erläutert. In der zugehörigen Zeichnung zeigen
- Fig. 1: ein Schaltschema einer Horizontalablenkschaltung mit einem Treibertransformator und
- Fig. 2: die Diagramme a) bis d) des schematisch dargestellten Signalverlaufes in der in Fig. 1 dargestellten Horizontalablenkschaltung.

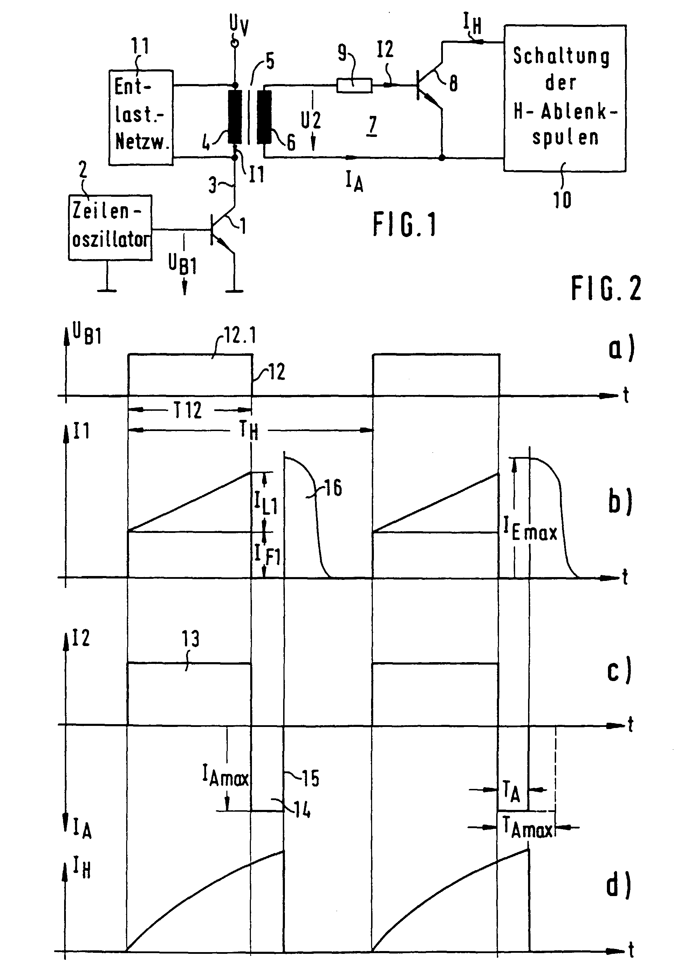

Figur 1 zeigt ein Schaltschema einer Horizontalablenkschaltung mit einem Treibertransistor 1, der von einem Zeilenfrequenzoszillator 2 gesteuert wird. Der Arbeitskreis 3 des Treibertransistors ist an eine Versorgungsspannung U_{V} einer nicht näher dargestellten Versorgungsspannungsquelle angeschlossen und enthält im wesentlichen die Primärwicklung 4 eines Treibertransformators 5, dessen Sekundärwicklung 6 Bestandteil des Steuerkreises 7 eines Zeilenendstufentransistors 8 der Horizontalablenkschaltung ist. Der Steuerkreis enthält außerdem einen Begrenzungswiderstand 9 zur Begrenzung des von der Sekundärspannung U2 des Treibertransformators erzeugten Steuerstromes I2 zur Steuerung in der Basisemitter-Strecke des Zeilenendstufentransistors 8. Dieser Steuerstrom I2 steuert den Ablenkstrom I_{H}, den der Zeilenendstufentransistor 8 für die Schaltung 10 der Ablenkspulen aufgrund des Steuerstromes I2 erzeugt. Während der Leitphase des Treibertransistors 1 fließt durch die Primärwicklung 4 des Treibertransformators 5 ein Arbeitsstrom I1. Außerdem ist an die Primärwicklung 4 des Treibertransistors ein Entlastungsnetzwerk 11 angeschlossen, das insbesondere dazu vorgesehen ist, den Treibertransistor vor zu hohen Spannungsspitzen zu schützen.

Die Arbeitsweise der Treiberstufe der Horizontalablenkschaltung wird nachfolgend anhand der Diagramme a) bis d) der Figur 2 näher erläutert. Im Diagramm a) ist die von dem Zeilenfrequenzoszillator 2 erzeugte Rechteckschwingung 12 dargestellt, die den Treibertransistor 1 an seiner Basis steuert und deren Impulsdauer T12 gleich der Hälfte der Schwingungsperiode T_{H} der Rechteckschwingung 12 des Zeilenfrequenzoszillators 2 ist. Die Impulse 12.1 der Rechteckspannung 12 steuern den Treibertransistor 1 in seinen Sättigungszustand, in dem er vollständig stromleitend ist und als Schalter für die Primärwicklung 4 des Treibertransistors 5 dient. Die Sekundärwicklung des Treibertransistors ist im Durchflußbetrieb so gepolt, daß die Steuerstrecke des Zeilenendstufentransistors 8 für den Steuerstrom I2 durchlässig ist, den der Treibertransformator 5 im Durchflußbetrieb entsprechend dem Verhältnis ü der Windungszahlen der Primär- und der Sekundärwicklung des Treibertransformators in den Steuerkreis 7 überträgt. Im Diagramm b) ist der im Arbeitskreis 3 des Treibertransistors 1 erzeugte Arbeitsstrom I1 durch die Primärwicklung 4 des Treibertransformators 5 schematisch dargestellt. Diagramm c) enthält eine schematische Darstellung des von der Sekundärspannung U2 im Steuerkreis 7 erzeugten Steuerstromes I2. Der in der Leitphase TL des Treibertransistors 1 fließende Arbeitsstrom I1 enthält zwei Stromanteile, nämlich den Durchflußstrom I_{F1}, der entsprechend dem Übersetzungsverhältnis ü in den Steuerkreis 7 des Zeilenendstufentransistors 8 übertragen wird, und einen dem Durchflußstrom I_{F1} überlagerten Ladestrom I_{L1}, der während der Leitphase TL des Treibertransistors 1 zum Ansammeln einer bestimmten magnetischen Energie E_{F1} im Treibertransformator dient. Die entsprechend dem Ladestrom I_{L1} in den Steuerkreis 7 übertragenen Steuerstromimpulse 13 schalten den Zeilenendstufentransistor 8 in den Durchlaßzustand, in dem er einen schematisch im Diagramm d) dargestellten Arbeitsstrom I_{H} für die Schaltung 10 der Ablenkspulen erzeugt.

Der im Steuerkreis 7 erzeugte, für die Steuerstrecke des Zeilenendstufentransistors 8 verhältnismäßig hohe Steuerstrom erzeugt im Basis-Emitterraum des Zeilenendstufentransistors 8 eine verhältnismäßig große Ladungsverschiebung, die der Ladung eines Kondensators im Basis-Emitterraum des Zeilenendstufentransistors entspricht und bei der Abschaltung des Steuerstromes I2 die Wirkung dieses Steuerstromes solange fortsetzt, bis diese Basis-Emitterladung abgebaut ist.

Es hat sich gezeigt, daß es von Vorteil ist, für den Abbau der Basis-Emitterladung einen optimalen Ausräumstrom I_{Aopt} einzustellen, bei dem die Zeilenendstufe und insbesondere der Zeilenendstufentransistor mit minimalen Verlustleistungen arbeitet. Zum Ausräumen der Basis-Emitterladung wird die Wirkung des Treibertransformators 5 in der Sperrphase Tsp des Treibertransistors 1 (Diagramm a)) ausgenutzt und die Primärinduktivität L1 des Treibertransformators 5 so bemessen, daß die in der Leitphase TL des Treibertransistors 1 in den Treibertransformator 5 eingespeicherte Energie in der Sperrphase Tsp des Treibertransistors einen Ausräumstromimpuls 14 erzeugt, der im Diagramm c) dargestellt ist und dessen Stromzeitfläche größer ist als die größte zu erwartende, aus dem Basis-Emitterraum des Zeilenendstufentransistors auszuräumende Ladung Q_{A}, und daß die Impulshöhe der Ausräumstromimpulse gleich dem optimalen Ausräumstrom I_{Aopt} für den Zeilenendstufentransistor ist. Die Primärinduktivität L1 ist deshalb so zu bemessen, daß der auf die Sekundärseite des Treibertransformators übertragene primäre Ladestrom I_{L1} am Ende der Leitphase TL des Treibertransistors 1 diesem Optimalwert I_{Aopt} des Ausräumstroms I_{A} entspricht. Andererseits muß der Treibertransformator so bemessen sein, daß er diesen Ausräumstrom in der Sperrphase Tsp wenigstens über die maximale Ausräumzeit T_{Amax} aufrechterhält. Der Ausräumvorgang ist beendet, wenn die in Sperrichtung betriebene Basis-Emitter-Strecke des Zeilenendstufentransistors 8 nach einer individuellen Ausräumzeit T_{A} in den Sperrzustand übergeht und damit den Ausräumstrom unterbricht. Dieser Zeitpunkt stellt die Rückflanke der Ausräumstromimpulse 14 dar, die im Diagramm c) mit dem Bezugszeichen 15 gekennzeichnet ist. Die danach noch im Treibertransformator 5 verbleibende überschüssige magnetische Energie sollte innerhalb der Sperrphase des Treibertransistors 1 durch eine entsprechende Schaltungsanordnung im Steuerkreis 7 oder im Primärkreis des Treibertransformators abgebaut werden. Im dargestellten Ausführungsbeispiel übernimmt das an die Primärwicklung 4 des Treibertransformators 5 angeschlossene Entlastungsnetzwerk 11 der Treiberstufe diesen Abbau beispielsweise derart, daß beim Überschreiten einer bestimmten Schwellspannung ein Ableitstrom entsteht, dessen Ableitstromimpulse 16 im Diagramm b) schematisch dargestellt sind und die einen maximalen Stromwert I_{Emax} nicht überschreiten.

## Patentansprüche

1. Horizontalablenkschaltung enthaltend einen Treibertransistor (1), einen Treibertransformator (5) mit einer zum Treibertransistor (1) in Serie geschalteten Primärinduktivität (L1) und einer Sekundärwicklung (6) und außerdem enthaltend einen Zeilenendstufentransistor (8), der über eine Begrenzungsimpedanz (9) mit der Sekundärwicklung (6) verbunden ist und von einem zur Sekundärwicklung (6) übertragenen Steuerstrom (I2) gesteuert wird, wobei die Sekundärwicklung (6) so gepolt ist, daß der Treibertransformator (5) für den Zeilenendstufentransistor (8) ein Durchflußwandler ist, wobei die Primärinduktivität (L1) so bemessen ist, daß der Treibertransformator (5) im Sperrzustand des Treibertransistors (1) während einer Zeit (T_{A}) zum Ausräumen einer im Basis-Emitter-Raum des Zeilenendstufentransistors (8) gespeicherten Ladung einen entgegengesetzt zum Steuerstrom (I2) gerichteten Ausräumstrom (I_{A}) eines Stromwertes (I_{Aopt}) erzeugt, wobei die während des Leitzustandes des Treibertransistors (1) im Treibertransformator (5) eingespeicherte Energie während des Sperrzustandes den Ausräumstrom (I_{A}) erzeugt, dessen Stromzeitfläche größer ist als die größte zu erwartende im Basis-Emitter-Raum gespeicherte Ladung
**dadurch gekennzeichnet,**
daß die Serienschaltung des Treibertransistors (1) und der Primärinduktivität (L1) direkt mit den Polen einer Versorgungsspannungsquelle verbunden ist,
daß die Begrenzungsimpedanz durch einen Begrenzungswiderstand (9) gebildet ist
und daß die Primärinduktivität (L1) so bemessen ist, daß am Ende des Leitzustandes der zur Sekundärwicklung (6) zu übertragende primäre Ladestrom I_{L1} dem Stromwert (I_{Aopt}) des Ausräumstromes (I_{A}) entspricht.

2. Horizontalablenkschaltung nach Anspruch 1, dadurch gekennzeichnet, daß ein Entlastungsnetzwerk (11) an den Treibertransformator (5) angeschlossen ist, das so ausgebildet ist, daß es beim Abbruch des Ausräumstromes (I_{A}) den vom Treibertransformator (5) im Sperrzustand des Treibertransistors (1) erzeugten verbleibenden Ausräumstrom übernimmt.

## Claims

1. Horizontal deflection circuit including a driving transistor (1), a driving transformer (5) with a primary inductance (L1) connected in series to the driving transistor (1) and with a secondary winding (6) and including in addition a horizontal-scan-output transistor (8) which is connected to the secondary winding (6) via a limiting impedance (9) and is controlled by a control current (I₂) transmitted to the secondary winding (6), the secondary winding (6) being polarised in such a way that the driving transformer (5) for the horizontal-scan-output transistor (8) is a flow converter, the value of the primary inductance (L1) being such that in the blocking state of the driving transistor (1) during a time (T_{A}) for clearing a charge stored in the base-emitter space of the horizontal-scan-output transistor (8) the driving transformer (5) generates a clearing current (I_{A}) having a current value (I_{Aopt}), the direction of which is opposite to that of the control current (I₂), whereby the energy that is stored in the driving transformer (5) during the conducting state of the driving transistor (1) generates the clearing current (I_{A}) during the blocking state, the current-time area of said clearing current being larger than the largest charge stored in the base-emitter space that is to be expected,
characterised in that
the series circuit of the driving transistor (1) and of the primary inductance (L1) is directly connected to the poles of a source of supply voltage,
the limiting impedance is constituted by a limiting resistor (9)
and the value of the primary inductance (L1) is such that at the end of the conducting state the primary charge current (I_{L1}) to be transmitted to the secondary winding (6) corresponds to the current value (I_{Aopt}) of the clearing current (I_{A}).

2. Horizontal deflection circuit according to Claim 1, characterised in that a load-reducing network (11) is connected to the driving transformer (5), said load-reducing network being so designed that in the event of termination of the clearing current (I_{A}) it accepts the remaining clearing current generated by the driving transformer (5) in the blocking state of the driving transistor (1).

## Revendications

1. Circuit de déviation horizontale contenant un transistor d'attaque (1), un transformateur d'attaque (5) avec une inductance primaire (L1) montée en série avec le transistor d'attaque (1) et un enroulement secondaire (6) et d'autre part contenant également un transistor à gradins de fin de ligne (8), qui est relié par une impédance de limitation (9) à l'enroulement secondaire (6) et est commandé par un courant de commande (I₂) transmis à l'enroulement secondaire (6), l'enroulement secondaire (6) étant polarisé de telle façon que le transformateur d'attaque (5) pour le transformateur à gradins de fin de ligne (8) soit un convertisseur de débit, l'inductance primaire (L1) étant dimensionnée de telle sorte que le transformateur d'attaque (5) génère un courant de sortie (IA), dirigé dans le sens opposé au courant de commande (I₂), d'une valeur de courant (I_{Aopt}) à l'état bloqué du transistor d'attaque (1) pendant une durée (T_{A}) pour la sortie d'une charge stockée dans l'espace émetteur/base du transistor à gradins de fin de ligne (8), l'énergie emmagasinée pendant l'état de conduction du transistor d'attaque (1) dans le transformateur d'attaque (5) générant pendant l'état de blocage le courant de sortie (I_{A}) dont la surface/temps de passage du courant est supérieure à la plus grande charge stockée à escompter dans l'espace émetteur/base, caractérisé en ce que le montage en série du transistor d'attaque (1) et de l'inductance primaire (L1) est relié directement aux pôles d'une source d'alimentation électrique, en ce que l'impédance de limitation est formée par une résistance de limitation (9) et en ce que l'inductance primaire (L1) est dimensionnée de telle façon que, à la fin de l'état de conduction, le courant de charge I_{L1} primaire à transmettre à l'enroulement secondaire (6) correspond à la valeur du courant (I_{Aopt}) du courant de sortie (I_{A}).

2. Circuit de déviation horizontale selon la revendication 1, caractérisé en ce qu'un réseau de décharge (11) est raccordé au transformateur d'attaque (5) qui est conçu de telle façon que, lors de l'interruption du courant de sortie (I_{A}), il prend en charge le courant de sortie restant généré par le transformateur d'attaque (5) dans l'état de blocage du transistor d'attaque (1).
